# EUROPEAN PATENT SPECIFICATION

(11) **EP 3 413 697 B1**
(45) Date of publication and mention of the grant of the patent: **14.08.2019**
(21) Application number: 17174569.8
(22) Date of filing: 06.06.2017
(51) Int. Cl.: H05K 7/02, H04L 12/24, H04L 12/773, H04W 88/16, H04L 12/46, H04L 12/775

(54) **CONFIGURATION OF A STACKABLE ACCESS POINT DEVICE (STAP)**
KONFIGURATION VON EINER STAPELBARE ZUGANGSPUNKTVORRICHTUNG (STAP)
CONFIGURATION D'UN DISPOSITIF DE POINT D'ACCÈS EMPILABLE (STAP)

(43) Date of publication of application: 12.12.2018
(73) Proprietor: Deutsche Telekom AG, 53113 Bonn (DE)
(72) Inventor: Bayer, Nico, 61231 Bad Nauheim (DE); Hänsge, Kay, 13086 Berlin (DE); Roos, Andreas, 64354 Reinheim (DE); Szczepanski, Roman, 10713 Berlin (DE)
(74) Representative: Raible Deissler Lehmann Patentanwälte PartG mbB

(56) References cited:
- US-A1- 2001 030 950
- US-A1- 2002 065 935
- US-A1- 2013 028 152
- US-A1- 2017 070 365

## Description

### TECHNICAL FIELD

The present disclosure relates to a stackable access point device (STAP) comprising a basic module and at least one access technology specific extension module. In a basic version the STAP includes only the basic module providing basic service without extension modules. The disclosure further relates to a stackable next generation access point device, in particular a flexible access point, router or computer architecture which is build up of STAPlets, i.e. one basic module and one or more extension modules which are stackable to form the STAP.

### BACKGROUND

On the user side of communication networks, e.g. for the home network, a multitude of different network components will be required to coexist. A router, access point or computer architecture, for example, will be required to provide connectivity to an enormous number of new applications and services as well as transmission media used to carry their signals and communication protocols to organize the network traffic.

Depending on the required service and the diverse requirements, the user may be required to configure his access point, router or home gateway. For example, the user may be required to adapt the software or firmware of his home gateway or may need further hardware components for implementing additional services, new use cases or alternative applications. A dynamic traffic routing may be required based on the configuration of the access point, router or home gateway. Configuring such dynamic traffic routing may be outside of the user's abilities.

US 2002/065935 A1 describes a method and system for a modular residential gateway. The scalable modular network system includes many kinds of voice and data components. In operation, the system provides trans-coding transparency allowing effective communications between dissimilar data/voice data streams.

US 2017/070365 A1 describes a modular home gateway multimedia router, in particular a router gateway device for sharing hardware and software resources and mounting multiple modular service hardware devices, where each service module delivers distinct functional network service to the end user.

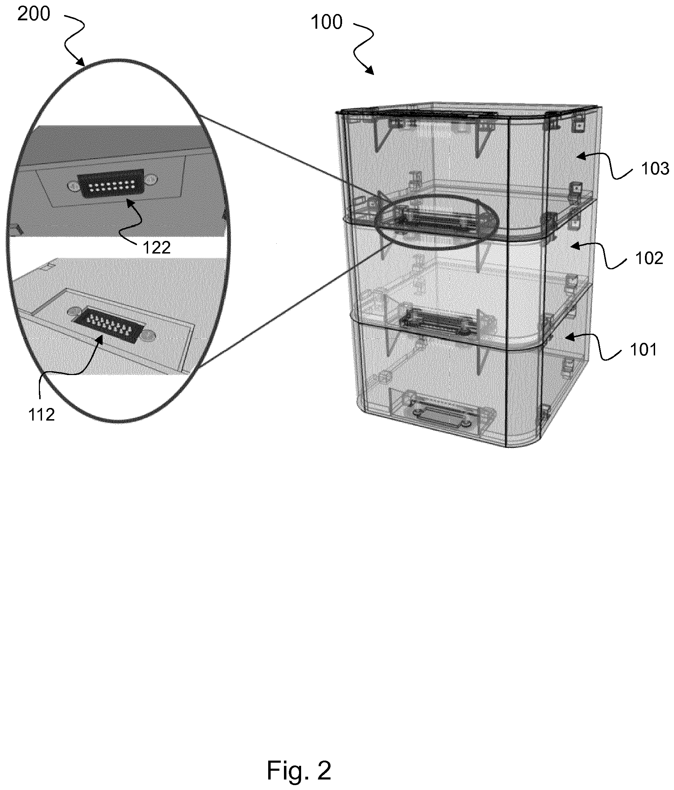

US 2013/028152 A1 describes a wireless access point with modular network elements (see title). Each network element module 210, 220, 250 (see Fig. 2) provides one or more added capabilities to the wireless AP, such as devices and/or services.

US 2001/030950 A1 describes a broadband communications access device, in particular an integrated phone-based home gateway system including a broadband communication device such as a DSL device, an analog modem, a wireless interface integrated into a screen-phone for providing broadband communication service to home users.

### SUMMARY

It is the object of the present invention to provide a concept for a flexible home gateway which is able to adapt to the diverse requirements of the users or customers, particularly with respect to the above requirements.

This object is achieved by the features of the independent claims. Further implementation forms are apparent from the dependent claims, the description and the figures.

In order to describe the invention in detail, the following terms, abbreviations and notations will be used:
- UE:: user equipment, user device
- AP:: access point
- STAP:: stackable access point
- STAPlet:: a module of a STAP
- DSL:: digital subscriber line
- IP:: Internet protocol
- 5G:: fifth generation mobile network
- LTE:: Long Term Evolution
- DHCP:: Dynamic Host Configuration Protocol
- GW:: gateway
- VLAN:: virtual LAN
- SDN:: software defined networking

In the following, stackable access point (STAP) devices are described. A STAP device is a flexible access point, router or computer device which is build up of STAPlets. STAPlets are hardware modules comprising different types of functionalities (e.g. computing and/or communication functionalities, etc.) to support specific services and/or applications. The STAP device normally comprises a basic module which enables basic connectivity, e.g. via Ethernet, to a communication network such as the Internet, basic computation capbilites and a bus system that allows to extend the basic module by just putting additional STAPlets, also called extension modules, on top of each other. These additional STAPlets can extend the STAP with additional hardware and functions in order to enable new service and/or supporting a new use case.

Such STAPlets may for example have a Wi-Fi module which is configured to work as a Wi-Fi access point. Other extensions might be a DSL modem to provide access to a DSL network an LTE modem to provide access to an LTE network or the extension may serve as a hybrid access module providing access resource bundling functionality.

The STAP device may be implemented by various modules built of various technologies, in particular based on mobile communication standards such as LTE, in particular LTE-A and/or OFDM and successor standards such as 5G or alternatively or additionally based on fixed networks communication standards such as DSL access networks, ISDN POTS, etc. The components and network nodes of such a STAP device may be implemented as electronic devices or electronic network entities. The described devices and network entities may include integrated circuits and/or passives and may be manufactured according to various technologies. For example, the circuits may be designed as logic integrated circuits, analog integrated circuits, mixed signal integrated circuits, optical circuits, memory circuits and/or integrated passives.

STAP devices as described in the following may include a software defined networking (SDN) controller that may configure data traffic based on SDN rules. Software-defined networking (SDN) is an approach in computer networking that allows network administrators to programmatically initialize, control, change, and manage network behavior dynamically via open interfaces and abstraction of lower-level functionality. This is done by decoupling or disassociating the system that makes decisions about where data traffic is sent (the SDN controller, or control plane) from the underlying systems that forward traffic to the selected destination (the data plane).

STAP devices as described in the following may include a Dynamic Host Configuration Protocol (DHCP) server that may configure data traffic based on IP routing. DHCP is a standardized network protocol used on Internet Protocol (IP) networks. The DHCP server dynamically distributes network configuration parameters, such as IP addresses, for interfaces and services. A router or a residential gateway can be enabled to act as a DHCP server. A DHCP server enables computers to request IP addresses and networking parameters automatically, reducing the need for a network administrator or a user to configure these settings manually.

STAP devices as described in the following may include a virtual LAN (VLAN) controller that may control data traffic by VLAN tagging. A VLAN is any broadcast domain that is partitioned and isolated in a computer network at the data link layer. VLANs work through tags within network packets and tag handling in networking systems creating the appearance and functionality of network traffic that is physically on a single network but acts as if it is split between separate networks. In this way, VLANs allow to group hosts together even if the hosts are not on the same network switch. This can greatly simplify network design and deployment, because VLAN membership can be configured through software. VLANs also allow networks and devices that must be kept separate to share the same physical cabling without interacting, for reasons of simplicity, security, traffic management, or economy. A VLAN, for example, can be used to separate traffic within a network between types of traffic, so that users or low priority traffic cannot directly affect the rest of the network's functioning.

According to a first aspect, the invention relates to a stackable access point (STAP) device, comprising: a basic module comprising a plurality of interfaces and a processor, wherein the processor is configured to route data traffic through the stackable access point device based on a configuration of the stackable access point device; and at least one access technology specific extension module comprising a plurality of interfaces and a processor, wherein the processor is configured to process the data traffic based on a respective access technology, wherein the at least one extension module is stackable with the basic module by electrically connecting at least one interface of the basic module with at least one interface of the at least one extension module, wherein the configuration of the stackable access point device is based on a number of extension modules stacked together with the basic module and an order in which the at least one extension modules are stacked together with the basic module. The processor of the basic module is configured to determine a specific routing path for routing the data traffic through the stackable access point device based on a specific configuration recipe received from a configuration database which comprises a plurality of configuration recipes associated with respective configurations of the stackable access point device.

Such a STAP device provides a flexible home gateway which is able to adapt to the diverse requirements of the users or customers. It enhances the flexibility of communication due to the stacking of a basic module together with one or more extension modules. The user can receive the required service without the need to adapt the software or firmware of his home gateway. The user can just use the corresponding extension modules providing the required service, use cases or applications without the need to configure dynamic traffic routing of the device. The user can use the corresponding extension module which provides an access technology according to his needs. The user can flexibly provide a stackable system by electrically (and mechanically) connecting the extension module(s) with the basic module. Then, connection to a communication network such as the Internet may be provided, e.g. based on Wi-Fi, DSL, cellular communication or any other access technology.

This STAP device provides the advantage that the processor of the basic module can flexibly provide the configuration recipe which fits to the current configuration of the STAP.

In an implementation form of the stackable access point device, a first extension module of the at least one extension modules is stackable with a second extension module of the at least one extension modules by electrically connecting at least one interface of the first extension module with at least one interface of the second extension module.

This provides the advantage that the extension modules are not only stackable with the basic module but also stackable with each other. Hence, any desired hardware configuration can be implemented by stacking the respective extension modules.

In an implementation form of the stackable access point device, the at least one extension module is stackable with the basic module by putting the at least one extension module and the basic module on top of each other or by putting the basic module and the at least one extension module on top of each other.

This provides the advantage that a flexible stacking can be realized, the basic module can be put on top of an extension module or the extension module can be put on top of the basic module or the basic module can be sandwiched between two (or more) extension modules. At least theoretically there is no limit to the number of extension modules which can be added.

In an implementation form of the stackable access point device, at least part of the interfaces of the basic module and at least part of the interfaces of the at least one extension module form a bus configured to electrically connect the basic module with the at least one extension module.

This provides the advantage that any standard bus topology can be used for implementing the stacking, e.g. USB, Ethernet, PCIe, etc. Hence, it is easy to connect a STAPlet such as the basic module or an extension module to the bus. Such a bus requires less cable length than a star topology resulting in lower costs.

In an implementation form of the stackable access point device, the processor of the basic module is configured to connect data traffic received via a first extension module of the at least one extension modules to a communication network such as the Internet or alternatively to an external wide area network (WAN) or an external local area network (LAN).

This provides the advantage that a compact STAP device can be produced including a basic module and one extension module where the extension module processes user traffic according to the used access technology, e.g. Wi-Fi, DSL, LTE, GSM, UMTS, etc. and the basic module connects the user traffic to a communication network such as the Internet.

In an implementation form of the stackable access point device, the processor of the first extension module is configured to process the data traffic based on a Wi-Fi access technology.

This provides the advantage that the STAP device can be used in the home network of a user for receiving the user traffic by a Wi-Fi access technology and connecting the user to a communication network such as the Internet by using the basic module.

In an implementation form of the stackable access point device, the processor of the basic module is configured to route data traffic received via a first extension module of the at least one extension modules to a second extension module of the at least one extension modules for connection to a communication network such as the Internet.

This provides the advantage that any number of extension modules can be used to route the data traffic between different access technology domains, for example from a Wi-Fi network to a DSL network. The STAP device thus provides flexilbe communication.

In an implementation form of the stackable access point device, the processor of the second extension module is configured to process the data traffic based on a digital subscriber line (DSL) access technology.

This provides the advantage that the STAP device can route the data traffic between a local area communication technology such as Wi-Fi to a fixed access network such as a DSL network.

In an implementation form of the stackable access point device, the processor of a third extension module of the at least one extension modules is configured to bundle data traffic received via at least one interface of the third extension module.

This provides the advantage that the STAP device can be implemented in a compact manner due to the bundling of data traffic.

In an implementation form of the stackable access point device, the processor of the third extension module is configured to route the bundled data traffic through the third extension module to a communication network such as the Internet via at least one of the following interfaces: a radio communication interface, a DSL interface, a Wi-Fi interface.

This provides the advantage that the STAP device can perform the routing for a plurality of different interfaces supporting different access technologies. Hence, the user can increase data throughput when bundling the data traffic and using all available access technologies.

In an implementation form of the stackable access point device, the processor of the basic module is configured to identify the configuration of the stackable access point device by detecting which extension modules are connected with the basic module and in which order the extension modules are connected with the basic module.

This provides the advantage that the STAP device is able to autonomously detect the current configuration of the STAP, i.e. which modules are currently connected with the basic module. Any change in the configuration can be quickly detected by the processor.

In an implementation form of the stackable access point device, the basic module comprises a network manager configured to switch data paths of the basic module and the at least one extension modules to form the specific routing path for routing the data traffic through the stackable access point device.

This provides the advantage that the network manager can flexibly find the optimal routing path which fits to the current configuration of the STAP device.

In an implementation form of the stackable access point device, the network manager comprises at least one of the following entities: a Software-Defined Networking (SDN) controller configured to switch the data paths based on SDN rules, a Dynamic Host Configuration Protocol (DHCP) server configured to switch the data paths based on Internet Protocol (IP) routing, a Virtual LAN (VLAN) controller configured to switch the data paths based on VLAN tags. Beside these solutions, there could be various other solutions not explicitly mentioned here.

This provides the advantage that different solution can be implemented to perform the routing, e.g. routing based on SDN, based on IP routing or based on VLAN tagging.

According to a second aspect, the invention relates to a method for routing data traffic through a stackable access point device comprising a basic module stacked together with at least one access technology specific extension module, the method comprising: identifying a configuration of the stackable access point device by detecting which extension modules are connected with the basic module and in which order the extension modules are connected with the basic module; determining a specific routing path for routing the data traffic through the stackable access point device based on the identified configuration; and switching data paths of the basic module and the at least one extension modules to form the specific routing path for routing the data traffic through the stackable access point device. Determining the specific routing path comprises determining the specific routing path based on a specific configuration recipe received from a configuration database which comprises a plurality of configuration recipes associated with respective configurations of the stackable access point device.

Such a method enhances the flexibility and reliability of communication due to the stacking of a basic module together with one of more extension modules. The user can use the corresponding extension module which provides an access technology according to his needs. The user can flexibly provide a stackable system by electrically (and mechanically) connecting the extension module(s) with the basic module. Then, connection to a communication network such as the Internet or an external WAN may be provided, e.g. based on Wi-Fi, DSL, cellular communication or any other access technology.

### BRIEF DESCRIPTION OF THE DRAWINGS

Further embodiments of the invention will be described with respect to the following figures, in which:
Fig. 1 shows a 3D view on an exemplary stackable computer architecture 100 according to the disclosure.
Fig. 2 shows a 3D view on an exemplary bus system 200 of the stackable computer architecture 100 according to the disclosure.
Fig. 3 shows a schematic diagram of a Wi-Fi access point 300 formed by a stackable access point (STAP) device according to the disclosure.
Fig. 4 shows a schematic diagram of a DSL router 400 formed by a STAP device according to the disclosure.
Fig. 5 shows a schematic diagram of a Hybrid router 500 formed by a STAP device according to the disclosure.
Fig. 6 shows a schematic diagram of a traffic management system 600 for a STAP device according to the disclosure.
Fig. 7 shows a schematic diagram of the general architecture of a STAP device 700 according to the disclosure.
Fig. 8 shows a schematic diagram of a method 800 for routing data traffic through a STAP device according to the disclosure.

### DETAILED DESCRIPTION OF EMBODIMENTS

In the following detailed description, reference is made to the accompanying drawings, which form a part thereof, and in which is shown by way of illustration specific aspects in which the disclosure may be practiced. It is understood that other aspects may be utilized and structural or logical changes may be made without departing from the scope of the present disclosure. The following detailed description, therefore, is not to be taken in a limiting sense, and the scope of the present disclosure is defined by the appended claims.

It is understood that comments made in connection with a described method may also hold true for a corresponding device or system configured to perform the method and vice versa. For example, if a specific method step is described, a corresponding device may include a unit to perform the described method step, even if such unit is not explicitly described or illustrated in the figures. Further, it is understood that the features of the various exemplary aspects described herein may be combined with each other, unless specifically noted otherwise.

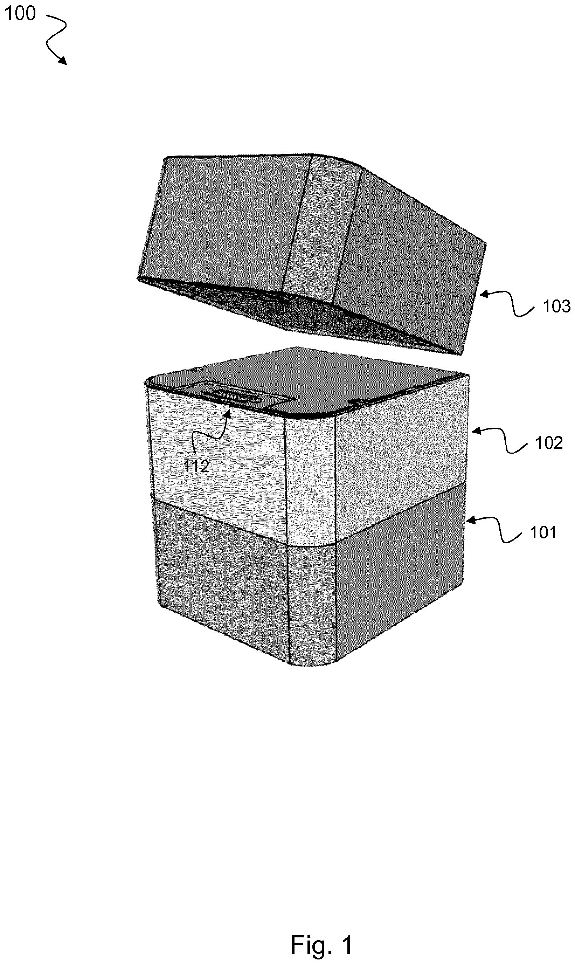

Fig. 1 shows a 3D view on an exemplary stackable computer architecture 100 according to the disclosure. The stackable next generation access point (STAP) 100 is a flexible access point, router or computer device which is build up of STAPlets 101, 102, 103. In the example of Fig. 1, three STAPlets 101, 102, 103 are shown. However, the STAP 100 may be build up of any other number of STAPlets, e.g. 2, 4, 5, 6, 7, 8, 9, 10, 20, etc. The STAP 100 normally comprises a basic module 101 which enables basic connectivity (e.g. via Ethernet) to a communication network such as the Internet, basic computation capabilities and a bus system 112 that allows to extend the basic module 101 by just putting additional STAPlets 102, 103 on top of each other, e.g. as shown in Fig. 1. These additional STAPlets (also called extension modules) 102, 103 can be extended with additional hardware and functions in order to enable a new service and/or supporting a new use case.

Fig. 2 shows a 3D view on an exemplary bus system 200 of the stackable computer architecture 100 according to the disclosure. An internal bus system 200 is physically connecting the STAPlets 101, 102, 103 with each other. For instance, the bus system 200 may provide power, USB and/or Ethernet connections. However, any other connections are possible as well. An example of the bus system 200 is displayed in Figure 2.

The different STAPlets 101, 102, 103 provide diverse features and functions. The function provided may also influence the way data packets are routed through the STAP 100. In the following figures, some examples are discussed in order to illustrate how data packets are treated in a different behaviour.

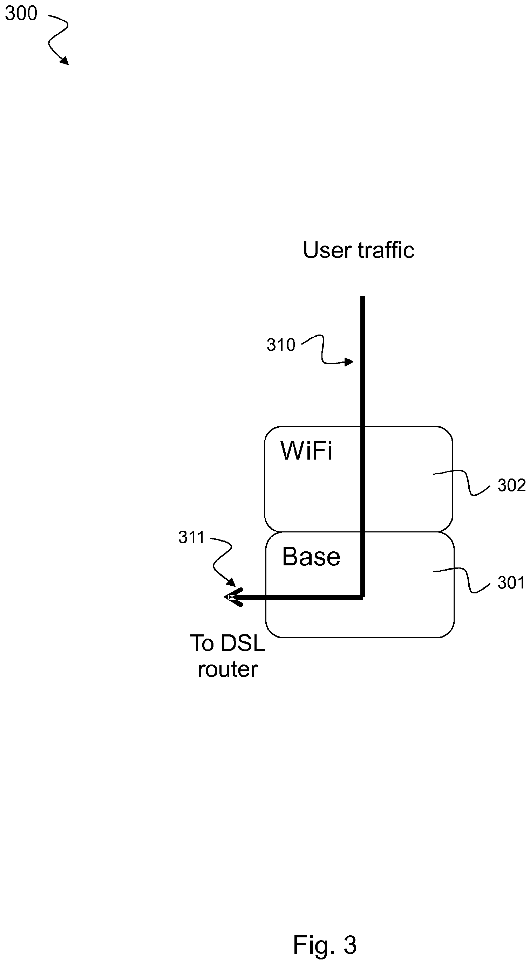

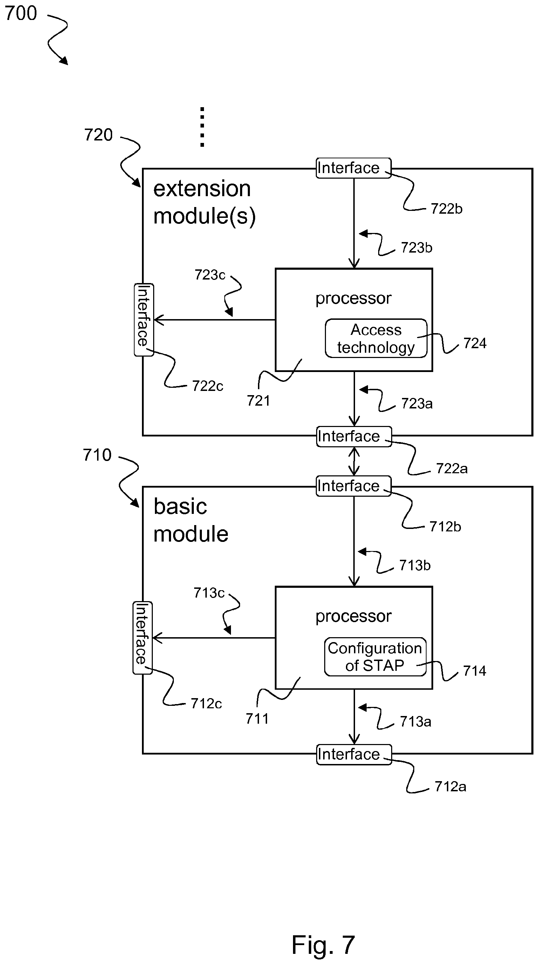

Fig. 3 shows a schematic diagram of a Wi-Fi access point 300 formed by a stackable access point (STAP) device according to the disclosure. The Wi-Fi AP 300 comprises the basic STAPlet 301, e.g. according to the basic module 101 depicted in Figures 1 and 2, combined with a Wi-Fi STAPlet 302, e.g. according to an extension module 102, 103 depicted in Figures 1 and 2, providing Wi-Fi functionality. In this scenario the customer with its Wi-Fi enabled device is connected to the Wi-Fi STAPlet 302 while the connection to the communication network such as the Internet is realised via the basic STAPlet 301 which is connected to the communication network, e.g. via a DSL router 311. The Wi-Fi STAPlet 302 processes the Wi-Fi user traffic 310, forwards this traffic 310 to the basic STAPlet 301 which forwards the traffic to a DSL router for providing connectivity to a communication network such as the Internet. Each STAPlet of the Wi-Fi access point 300 may include one or more interfaces to receive and transmit/forward the data traffic and a processor for processing the data traffic. A detailed architecture of such a Wi-Fi access point 300 is described below with respect to Fig. 7.

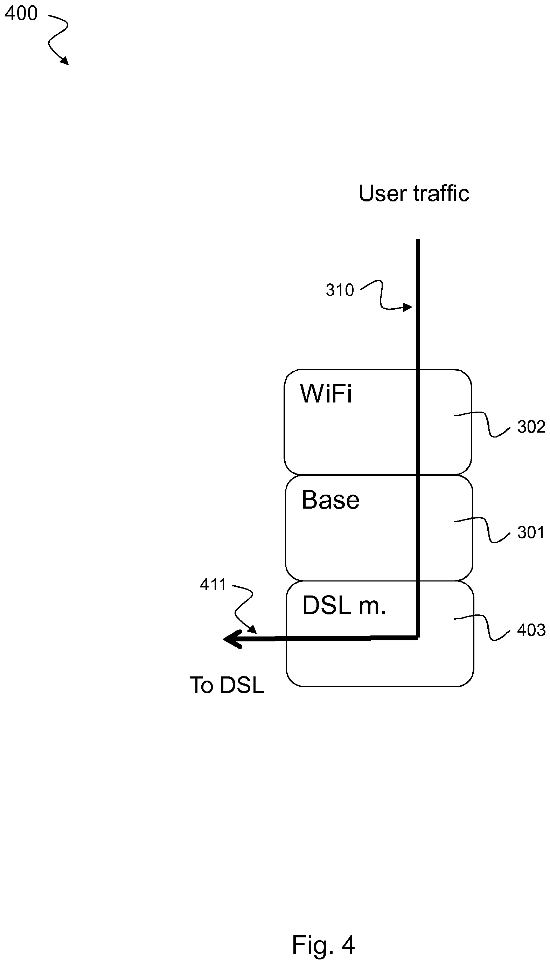

Fig. 4 shows a schematic diagram of a DSL router 400 formed by a STAP device according to the disclosure.

The DSL router 400 comprises the basic STAPlet 301, e.g. according to the basic module 101 depicted in Figures 1 and 2, combined with a Wi-Fi STAPlet 302, e.g. according to an extension module 102, 103 depicted in Figures 1 and 2, providing Wi-Fi functionality. In addition to the Wi-Fi AP 300 shown in Fig. 3, the DSL router 400 comprises a DSL modem 403 on the bottom of the STAP 400. Another difference is that the traffic 411 towards the communication network such as the Internet is not going out of the basic STAPlet 301 as shown in Fig. 3, but via the DSL STAPlet 403.

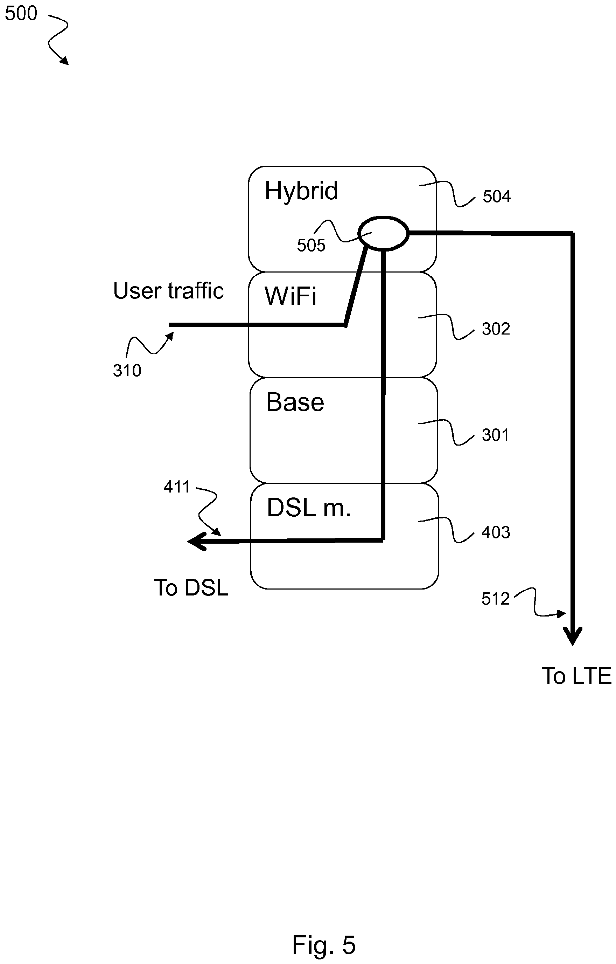

Fig. 5 shows a schematic diagram of a Hybrid (access) router 500 formed by a STAP device according to the disclosure. This router 500 additionally has a Hybrid STAPlet 504 on top (with respect to the DSL router 400 depicted in Fig. 4). The Hybrid STAPlet 504 adds a mobile communication, e.g. LTE, interface 512 as well as a bonding functionality 505. Traffic flows in this scenario are very different compared to the previous scenarios. All customer traffic 310 (to the communication network such as the Internet) is routed through the Hybrid STAPlet 504. Also in addition to the network access 411 via the DSL STAPlet 403 a network access via the LTE interface 512 within the Hybrid STAPlet 504 is available.

The configuration of the STAP, meaning the STAPlets added as well as the order of the STAPlets have an influence on the way traffic is forwarded through the STAP and requires a dynamic traffic management function as described in the following.

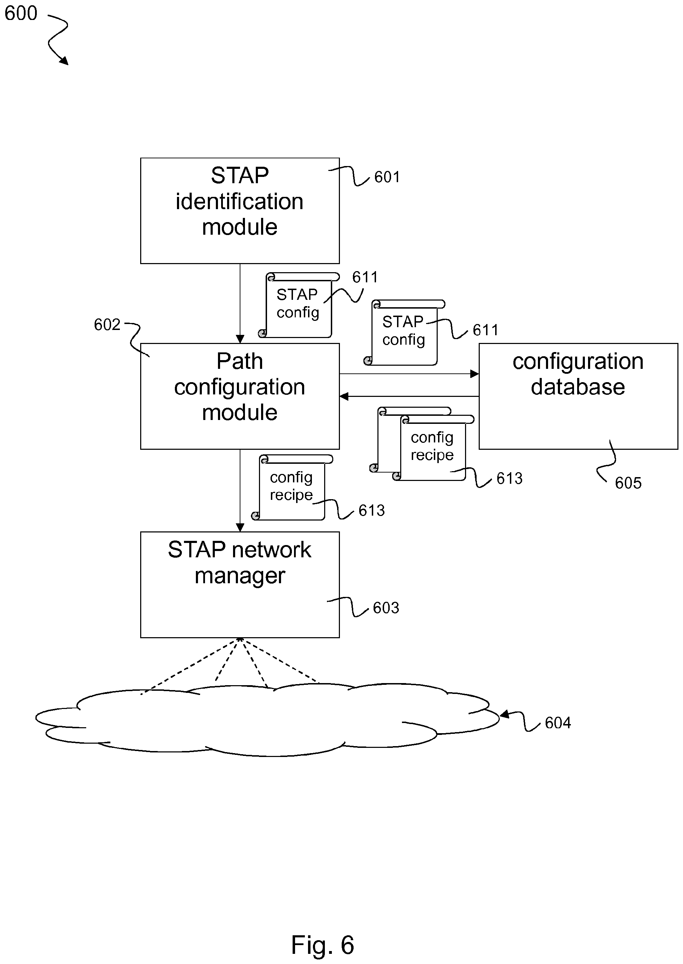

Fig. 6 shows a schematic diagram of a traffic management system 600 for a STAP device according to the disclosure. The system shown in Figure 6 is able to change the way traffic is forwarded/steered through the STAP, e.g. the STAP device as described above with respect to Figures 1 to 5, based on the STAP configuration and the order of the STAPlets. The system includes a STAP identification module 601 which identifies the current STAP configuration 611, e.g. by querying through the interfaces which type of extension modules are connected to the basic module and in which order these extension modules are connected to the basic module. The system further includes of a path computation module 602 which takes the current STAP configuration 611 as input. The STAP configuration 611 may be represented as a list of STAPlets which are currently part of the STAP. In order to know how to configure the STAP, the path computation module 602 may forward the current STAP configuration 611 to a configuration database 605. The database 605 in return may reply to the path computation module 602 the configuration recipe 613 which is valid (best match) for the current STAP configuration 611. Based on this recipe 613 the path computation module 602 performs the STAP traffic configuration with the help of the STAP network manager 603. The STAP network manager 603 is the entity which is performing the respective configuration steps to configure data paths to the network 604.

The STAP identification module 601, the path computation module 602 and the STAP network manager 603 may for example be implemented in a basic module of the STAP, e.g. a basic module 101 or 301 as described above with respect to Figures 1 to 5.

The traffic flows may be configured according to different solutions. For example according to an SDN-based solution, an IP routing based solution and a VLAN based solution.

The SDN-based solution uses SDN enabled devices (e.g. switches and nodes) within the STAP to perform the traffic configuration. In that case the STAP network manager 603 may include a SDN controller which configures traffic flows within the STAP based on SDN rules configured on the switches and the nodes.

For the IP routing based approach the key entity is a DHCP server. Based on the current STAP configuration, the DHCP server assigns different default gateway (GW) IP addresses to the different nodes in order to steer the traffic within the STAP.

For the VLAN based approach, a controller provides VLAN tagging to configure the traffic flows.

Fig. 7 shows a schematic diagram of the general architecture of a STAP device 700 according to the disclosure. The STAP device 700 includes a basic module 710, e.g. a module 101, 301 as described above with respect to Figures 1 to 5, and optionally one or more access technology specific extension modules, e.g. modules 102, 103, 302, 403, 504 as described above with respect to Figures 1 to 5. Note that a STAPlet such as the basic module 710 or any of the extension modules 720 not necessarily always has a communication module/interface. Some STAPlets also just offer computation, storage or any other sort of functionality.

The basic module 710 includes a plurality of interfaces 712a, 712b, 712c and a processor 711. The processor 711 is configured to route data traffic 713a, 713b, 713c through the stackable access point device 700 based on a configuration 714 of the stackable access point device 700. The at least one access technology specific extension module 720 includes a plurality of interfaces 722a, 722b, 722c and a processor 721. The processor 721 is configured to process the data traffic 723a, 723b, 723c based on a respective access technology 724. The at least one extension module 720 is stackable with the basic module 710, e.g. as shown above with respect to Figs. 1 and 2, by electrically connecting at least one interface 712b of the basic module 710 with at least one interface 722a of the at least one extension module 720. The configuration 714 of the stackable access point device 700 is based on a number of extension modules 720 stacked together with the basic module 710 and an order in which the at least one extension modules 720 are stacked together with the basic module 710.

The stackable connection may be an electrical and/or mechanical connection of both modules. The extension module 720 may be put on the basic module 710 or below the basic module 710 and connected via the interfaces. The interfaces may be connected via a plug connection or via cables.

A first extension module, e.g. an extension module 102 as described above with respect to Figures 1 and 2, of the plurality of extension modules 720 may be stackable with a second extension module, e.g. an extension module 103 as described above with respect to Figures 1 and 2, of the plurality of extension modules 720 by electrically connecting at least one interface 112 of the first extension module 102 with at least one interface 122 of the second extension module 103.

The extension modules 720, 102 are stackable with the basic module 710, 101 by putting one or more extension modules 720, 102 and the basic module 710, 101 on top of each other or vice versa, i.e. by putting the basic module 710, 101 and the one or more extension modules 720, 102 on top of each other.

At least part of the interfaces 712a, 712b, 712c of the basic module 710 and at least part of the interfaces 722a, 722b, 722c of the one or more extension modules 720 may form a bus 200 which is configured to electrically and optionally also mechanically connect the basic module 710 with the one or more extension modules 720.

The processor 711 of the basic module 710, 301 may be configured to connect data traffic 310 received via a first extension module 302 to a communication network such as the Internet, e.g. as shown above with respect to Fig. 3. The processor 711 of the first extension module 302 may be configured to process the data traffic 310 based on a Wi-Fi access technology.

The processor 711 of the basic module 710, 301 may be configured to route data traffic 310 received via a first extension module 302 to a second extension module 403 for connection to a communication network such as the Internet, e.g. as described above with respect to Fig. 4. The processor 721 of the second extension module 403 may be configured to process the data traffic 310 based on a digital subscriber line DSL access technology, e.g. as described above with respect to Fig. 4.

The processor 721 of a third extension module, e.g. a hybrid (router) module 504 as described above with respect to Fig. 5, may be configured to bundle 505 data traffic 510 received via at least one interface of the third extension module 504. The processor 721 of the third extension module 504 may be configured to route the bundled data traffic through the third extension module 504 to a communication network such as the Internet via at least one of the following interfaces: a radio communication interface 512, e.g. an LTE interface, a DSL interface 411, or a Wi-Fi interface.

The processor 711 of the basic module 710 may be configured to identify 601 the configuration 714, 611 of the stackable access point device 700 by detecting which extension modules 720 are connected with the basic module 710 and in which order the extension modules 720 are connected with the basic module 710, e.g. as described above with respect to Fig. 6.

The processor 711 of the basic module 710 may be configured to determine a specific routing path for routing the data traffic 713a, 713b, 713c through the stackable access point device 700 based on a specific configuration recipe 613 received from a configuration database 605, e.g. as described above with respect to Fig. 6. The configuration database 605 may include a plurality of configuration recipes 613 associated with respective configurations 611 of the stackable access point device 700.

The basic module 710 may include a network manager 603 which may be configured to switch data paths of the basic module 710 and the at least one extension modules 720 to form the specific routing path for routing the data traffic 713a, 713b, 713c, 723a, 723b, 723c through the stackable access point device 700.

The network manager 603 may include a Software-Defined Networking (SDN) controller configured to switch the data paths based on SDN rules as describe above. The network manager 603 may include a Dynamic Host Configuration Protocol (DHCP) server configured to switch the data paths based on Internet Protocol (IP) routing as describe above. The network manager 603 may include a Virtual LAN (VLAN) controller configured to switch the data paths based on VLAN tags as described above.

Some STAP devices may just include a basic module which operates in a basic configuration of the STAP device 700 in a stand-alone mode without extension modules 720 and is configured to provide a basic service for the data traffic.

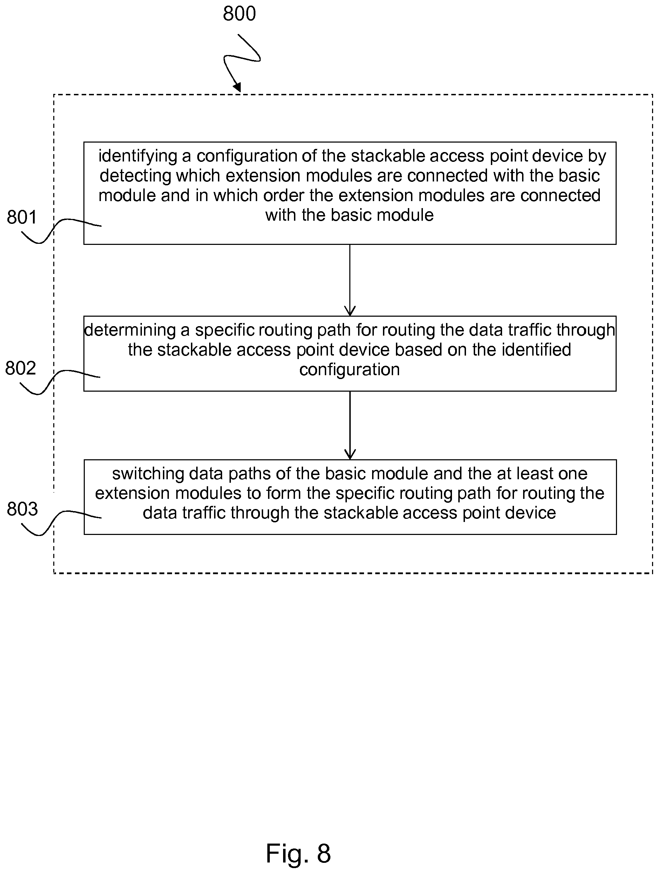

Fig. 8 shows a schematic diagram of a method 800 for routing data traffic through a STAP device according to the disclosure.

The STAP may include a basic module stacked together with at least one access technology specific extension module, e.g. as described above with respect to Figures 1 to 5.

The method 800 includes identifying 801 a configuration of the stackable access point device by detecting which extension modules are connected with the basic module and in which order the extension modules are connected with the basic module. The identification 801 may be performed by an identification module 601 as described above with respect to Fig. 6.

The method 800 further includes determining 802 a specific routing path for routing the data traffic through the stackable access point device based on the identified configuration. The determining 802 may be performed by a path configuration module 602 as described above with respect to Fig. 6.

The method 800 further includes switching 803 data paths of the basic module and the at least one extension modules to form the specific routing path for routing the data traffic through the stackable access point device. The switching 803 may be performed by a network manager 603 as described above with respect to Fig. 6.

The methods, systems and devices described herein may be implemented as electrical and/or optical circuit within a chip or an integrated circuit or an application specific integrated circuit (ASIC). The invention can be implemented in digital and/or analogue electronic and optical circuitry.

The methods, systems and devices described herein may be implemented as software in a Digital Signal Processor (DSP), in a micro-controller or in any other side-processor or as hardware circuit within an application specific integrated circuit (ASIC) of a Digital Signal Processor (DSP).

The invention can be implemented in digital electronic circuitry, or in computer hardware, firmware, software, or in combinations thereof, e.g. in available hardware of conventional optical transceiver devices or in new hardware dedicated for processing the methods described herein.

The present disclosure also supports a computer program product including computer executable code or computer executable instructions that, when executed, causes at least one computer to execute the performing and computing steps described herein, in particular the method 800 as described above with respect to Fig. 8 and the techniques described above with respect to Figs. 1 to 7. Such a computer program product may include a readable non-transitory storage medium storing program code thereon for use by a computer. The program code may perform the methods and techniques as described above with respect to Figures 1 to 8.

While a particular feature or aspect of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.

Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

Many alternatives, modifications, and variations will be apparent to those skilled in the art in light of the above teachings. Of course, those skilled in the art readily recognize that there are numerous applications of the invention beyond those described herein. While the present invention has been described with reference to one or more particular embodiments, those skilled in the art recognize that many changes may be made thereto without departing from the scope of the present invention. It is therefore to be understood that within the scope of the appended claims, the invention may be practiced otherwise than as specifically described herein.

## Claims

1. A stackable access point device (700), comprising:
a basic module (710) comprising a plurality of interfaces (712a, 712b, 712c) and a processor (711), wherein the processor (711) is configured to route data traffic (713a, 713b, 713c) through the stackable access point device (700) based on a configuration (714) of the stackable access point device (700); and
at least one access technology specific extension module (720) comprising a plurality of interfaces (722a, 722b, 722c) and a processor (721), wherein the processor (721) is configured to process the data traffic (723a, 723b, 723c) based on a respective access technology (724),
wherein the at least one extension module (720) is stackable with the basic module (710) by electrically connecting at least one interface (712b) of the basic module (710) with at least one interface (722a) of the at least one extension module (720),
wherein the configuration (714) of the stackable access point device (700) is based on a number of extension modules (720) stacked together with the basic module (710) and an order in which the at least one extension modules (720) are stacked together with the basic module (710),
**characterized in that**
the processor (711) of the basic module (710) is configured to determine a specific routing path for routing the data traffic (713a, 713b, 713c) through the stackable access point device (700) based on a specific configuration recipe (613) received from a configuration database (605),
wherein the configuration database (605) comprises a plurality of configuration recipes (613) associated with respective configurations (611) of the stackable access point device (700).

2. The stackable access point device (700, 100) of claim 1,
wherein a first extension module (102) of the at least one extension modules (720) is stackable with a second extension module (103) of the at least one extension modules (720) by electrically connecting at least one interface (112) of the first extension module (102) with at least one interface (122) of the second extension module (103).

3. The stackable access point device (700, 100) of claim 1 or 2,
wherein the at least one extension module (720, 102) is stackable with the basic module (710, 101) by putting the at least one extension module (720, 102) and the basic module (710, 101) on top of each other or by putting the basic module (710, 101) and the at least one extension module (720, 102) on top of each other.

4. The stackable access point device (700, 100) of one of the preceding claims,
wherein at least part of the interfaces (712a, 712b, 712c) of the basic module (710) and at least part of the interfaces (722a, 722b, 722c) of the at least one extension module (720) form a bus (200) configured to electrically connect the basic module (710) with the at least one extension module (720).

5. The stackable access point device (700, 300) of one of the preceding claims,
wherein the processor (711) of the basic module (710, 301) is configured to connect data traffic (310) received via a first extension module (302) of the at least one extension modules (720) to a communication network.

6. The stackable access point device (700, 300) of claim 5,
wherein the processor (711) of the first extension module (302) is configured to process the data traffic (310) based on a Wi-Fi access technology.

7. The stackable access point device (700, 400) of one of the preceding claims,
wherein the processor (711) of the basic module (710, 301) is configured to route data traffic (310) received via a first extension module (302) of the at least one extension modules (720) to a second extension module (403) of the at least one extension modules (720) for connection to a communication network.

8. The stackable access point device (700, 400) of claim 7,
wherein the processor (721) of the second extension module (403) is configured to process the data traffic (310) based on a digital subscriber line (DSL) access technology.

9. The stackable access point device (700, 500) of one of the preceding claims,
wherein the processor (721) of a third extension module (504) of the at least one extension modules (720) is configured to bundle (505) data traffic (510) received via at least one interface of the third extension module (504).

10. The stackable access point device (700, 500) of claim 9,
wherein the processor (721) of the third extension module (504) is configured to route the bundled data traffic through the third extension module (504) to a communication network via at least one of the following interfaces: a radio communication interface (512), a DSL interface (411), a Wi-Fi interface.

11. The stackable access point device (700) of one of the preceding claims,
wherein the processor (711) of the basic module (710) is configured to identify (601) the configuration (714, 611) of the stackable access point device (700) by detecting which extension modules (720) are connected with the basic module (710) and in which order the extension modules (720) are connected with the basic module (710).

12. The stackable access point device (700) of one of the preceding claims,
wherein the basic module (710) comprises a network manager (603) configured to switch data paths of the basic module (710) and the at least one extension modules (720) to form the specific routing path for routing the data traffic (713a, 713b, 713c, 723a, 723b, 723c) through the stackable access point device (700).

13. The stackable access point device (700) of claim 12,
wherein the network manager (603) comprises at least one of the following entities:
a Software-Defined Networking (SDN) controller configured to switch the data paths based on SDN rules,
a Dynamic Host Configuration Protocol (DHCP) server configured to switch the data paths based on Internet Protocol (IP) routing,
a Virtual LAN (VLAN) controller configured to switch the data paths based on VLAN tags.

14. A method (800) for routing data traffic through a stackable access point device comprising a basic module stacked together with at least one access technology specific extension module, the method comprising:
identifying (801) a configuration of the stackable access point device by detecting which extension modules are connected with the basic module and in which order the extension modules are connected with the basic module;
determining (802) a specific routing path for routing the data traffic through the stackable access point device based on the identified configuration; and
switching (803) data paths of the basic module and the at least one extension modules to form the specific routing path for routing the data traffic through the stackable access point device,
**characterized in that**
determining (802) the specific routing path comprises determining the specific routing path based on a specific configuration recipe (613) received from a configuration database (605),
wherein the configuration database (605) comprises a plurality of configuration recipes (613) associated with respective configurations (611) of the stackable access point device.

15. Basic module (710) of a stackable access point device (700), the basic module (710) comprising:
a plurality of interfaces (712a, 712b, 712c); and
a processor (711), configured to route data traffic (713a, 713b, 713c) through the stackable access point device (700) based on a configuration (714) of the stackable access point device (700),
wherein the basic module (710) is stackable with at least one extension module (720) of the stackable access point device (700) by electrically connecting at least one interface (712b) of the basic module (710) with at least one interface (722a) of the at least one extension module (720),
wherein the configuration (714) of the stackable access point device (700) is based on a number of extension modules (720) stacked together with the basic module (710) and an order in which the at least one extension modules (720) are stacked together with the basic module (710),
**characterized in that**
the processor (711) of the basic module (710) is configured to determine a specific routing path for routing the data traffic (713a, 713b, 713c) through the stackable access point device (700) based on a specific configuration recipe (613) received from a configuration database (605),
wherein the configuration database (605) comprises a plurality of configuration recipes (613) associated with respective configurations (611) of the stackable access point device (700).

16. The basic module (710) of claim 15,
wherein in a basic configuration of the stackable access point device (700) the basic module (710) is configured to operate in a stand-alone mode without extension modules (720) and is configured to provide a basic service for the data traffic (713a, 713b, 713c).

## Patentansprüche

1. Stapelbare Zugangspunktvorrichtung (700), die Folgendes umfasst:
ein Basismodul (710), das eine Vielzahl von Schnittstellen (712a, 712b, 712c) und einen Prozessor (711) umfasst, wobei der Prozessor (711) dazu ausgelegt ist, Datenverkehr (713a, 713b, 713c) auf Basis einer Konfiguration (714) der stapelbaren Zugangspunktvorrichtung (700) über die stapelbare Zugangspunktvorrichtung (700) zu routen; und
mindestens ein zugangstechnologiespezifisches Erweiterungsmodul (720), das eine Vielzahl von Schnittstellen (722a, 722b, 722c) und einen Prozessor (721) umfasst, wobei der Prozessor (721) dazu ausgelegt ist, den Datenverkehr (723a, 723b, 723c) auf Basis einer jeweiligen Zugangstechnologie (724) zu verarbeiten,
wobei das mindestens eine Erweiterungsmodul (720) durch elektrisches Verbinden von mindestens einer Schnittstelle (712b) des Basismoduls (710) mit mindestens einer Schnittstelle (722a) des mindestens einen Erweiterungsmoduls (720) mit dem Basismodul (710) stapelbar ist,
wobei die Konfiguration (714) der stapelbaren Zugangspunktvorrichtung (700) auf einer Anzahl von Erweiterungsmodulen (720), die mit dem Basismodul (710) zusammengestapelt sind, und einer Reihenfolge, in der die mindestens ein Erweiterungsmodule (720) mit dem Basismodul (710) zusammengestapelt sind, basiert,
**dadurch gekennzeichnet, dass**
der Prozessor (711) des Basismoduls (710) dazu ausgelegt ist, auf Basis eines spezifischen Konfigurationsrezepts (613), das von einer Konfigurationsdatenbank (605) empfangen wird, einen spezifischen Routingpfad zum Routen des Datenverkehrs (713a, 713b, 713c) über die stapelbare Zugangspunktvorrichtung (700) zu bestimmen,
wobei die Konfigurationsdatenbank (605) eine Vielzahl von Konfigurationsrezepten (613) umfasst, die mit jeweiligen Konfigurationen (611) der stapelbaren Zugangspunktvorrichtung (700) verknüpft sind.

2. Stapelbare Zugangspunktvorrichtung (700, 100) nach Anspruch 1,
wobei ein erstes Erweiterungsmodul (102) der mindestens ein Erweiterungsmodule (720) durch elektrisches Verbinden von mindestens einer Schnittstelle (112) des ersten Erweiterungsmoduls (102) mit mindestens einer Schnittstelle (122) eines zweiten Erweiterungsmoduls (103) mit dem zweiten Erweiterungsmodul (103) der mindestens ein Erweiterungsmodule (720) stapelbar ist.

3. Stapelbare Zugangspunktvorrichtung (700, 100) nach Anspruch 1 oder 2,
wobei das mindestens eine Erweiterungsmodul (720, 102) durch Aufeinandersetzen des mindestens einen Erweiterungsmoduls (720, 102) und des Basismoduls (710, 101) oder durch Aufeinandersetzen des Basismoduls (710, 101) und des mindestens einen Erweiterungsmoduls (720, 102) mit dem Basismodul (710, 101) stapelbar ist.

4. Stapelbare Zugangspunktvorrichtung (700, 100) nach einem der vorhergehenden Ansprüche,
wobei mindestens ein Teil der Schnittstellen (712a, 712b, 712c) des Basismoduls (710) und mindestens ein Teil der Schnittstellen (722a, 722b, 722c) des mindestens einen Erweiterungsmoduls (720) einen Bus (200) bilden, der dazu ausgelegt ist, das Basismodul (710) elektrisch mit dem mindestens einen Erweiterungsmodul (720) zu verbinden,

5. Stapelbare Zugangspunktvorrichtung (700, 300) nach einem der vorhergehenden Ansprüche,
wobei der Prozessor (711) des Basismoduls (710, 301) dazu ausgelegt ist, Datenverkehr (310), der via ein erstes Erweiterungsmodul (302) der mindestens ein Erweiterungsmodule (720) empfangen wird, mit einem Kommunikationsnetzwerk zu verbinden.

6. Stapelbare Zugangspunktvorrichtung (700, 300) nach Anspruch 5,
wobei der Prozessor (711) des ersten Erweiterungsmoduls (302) dazu ausgelegt ist, den Datenverkehr (310) auf Basis einer Wi-Fi-Zugangstechnologie zu verarbeiten.

7. Stapelbare Zugangspunktvorrichtung (700, 400) nach einem der vorhergehenden Ansprüche,
wobei der Prozessor (711) des Basismoduls (710, 301) dazu ausgelegt ist, Datenverkehr (310), der über ein erstes Erweiterungsmodul (302) der mindestens ein Erweiterungsmodule (720) empfangen wird, zur Verbindung mit einem Kommunikationsnetzwerk zu einem zweiten Erweiterungsmodul (403) der mindestens ein Erweiterungsmodule (720) zu routen.

8. Stapelbare Zugangspunktvorrichtung (700, 400) nach Anspruch 7,
wobei der Prozessor (721) des zweiten Erweiterungsmoduls (403) dazu ausgelegt ist, den Datenverkehr (310) auf Basis einer digitalen Teilnehmeranschlussleitungs(DSL)-Zugangstechnologie zu verarbeiten.

9. Stapelbare Zugangspunktvorrichtung (700, 500) nach einem der vorhergehenden Ansprüche,
wobei der Prozessor (721) eines dritten Erweiterungsmoduls (504) der mindestens ein Erweiterungsmodule (720) dazu ausgelegt ist, Datenverkehr (510), der via mindestens eine Schnittstelle des dritten Erweiterungsmoduls (504) empfangen wird, zu bündeln (505).

10. Stapelbare Zugangspunktvorrichtung (700, 500) nach Anspruch 9,
wobei der Prozessor (721) des dritten Erweiterungsmoduls (504) dazu ausgelegt ist, den gebündelten Datenverkehr via mindestens eine der folgenden Schnittstellen: eine Funkkommunikationsschnittstelle (512), eine DSL-Schnittstelle (411), eine Wi-Fi-Schnittstelle über das dritte Erweiterungsmodul (504) zu einem Kommunikationsnetzwerk zu routen.

11. Stapelbare Zugangspunktvorrichtung (700) nach einem der vorhergehenden Ansprüche,
wobei der Prozessor (711) des Basismoduls (710) dazu ausgelegt ist, durch Detektieren, welche Erweiterungsmodule (720) mit dem Basismodul (710) verbunden sind und in welcher Reihenfolge die Erweiterungsmodule (720) mit dem Basismodul (710) verbunden sind, die Konfiguration (714, 611) der stapelbaren Zugangspunktvorrichtung (700) zu identifizieren (601).

12. Stapelbare Zugangspunktvorrichtung (700) nach einem der vorhergehenden Ansprüche,
wobei das Basismodul (710) einen Netzwerkmanager (603) umfasst, der dazu ausgelegt ist, Datenpfade des Basismoduls (710) und der mindestens ein Erweiterungsmodule (720) zu schalten, um einen spezifischen Routingpfad zum Routen des Datenverkehrs (713a, 713b, 713c, 723a, 723b, 723c) über die stapelbare Zugangspunktvorrichtung (700) zu bilden.

13. Stapelbare Zugangspunktvorrichtung (700) nach Anspruch 12,
wobei der Netzwerkverwalter (603) mindestens eine der folgenden Entitäten umfasst:
eine softwaredefinierte Vernetzungs(SDN)-Steuerung, die dazu ausgelegt ist, die Datenpfade auf Basis von SDN-Regeln zu schalten,
einen DHCP-Server, der dazu ausgelegt ist, die Datenpfade auf Basis eines Internetprotokoll(IP)-Routens zu schalten,
eine virtuelle LAN(VLAN)-Steuerung, die dazu ausgelegt ist, die Datenpfade auf Basis von VLAN-Tags zu schalten.

14. Verfahren (800) zum Routen von Datenverkehr über eine stapelbare Zugangspunktvorrichtung, die ein Basismodul umfasst, das mit mindestens einem zugangstechnologiespezifischen Erweiterungsmodul zusammengestapelt ist, wobei das Verfahren Folgendes umfasst:
Identifizieren (801) einer Konfiguration der stapelbaren Zugangspunktvorrichtung durch Detektieren, welche Erweiterungsmodule mit dem Basismodul verbunden sind und in welcher Reihenfolge die Erweiterungsmodule mit dem Basismodul verbunden sind;
Bestimmen (802) eines spezifischen Routingpfades zum Routen des Datenverkehrs über die stapelbare Zugangspunktvorrichtung auf Basis der identifizierten Konfiguration und
Schalten (803) von Datenpfaden des Basismoduls und der mindestens ein Erweiterungsmodule, um einen spezifischen Routingpfad zum Routen des Datenverkehrs über die stapelbare Zugangspunktvorrichtung zu bilden,
**dadurch gekennzeichnet, dass**
das Bestimmen (802) des spezifischen Routingpfades das Bestimmen des spezifischen Routingpfades auf Basis eines spezifischen Konfigurationsrezepts (613), das von einer Konfigurationsdatenbank (605) empfangen wird, umfasst,
wobei die Konfigurationsdatenbank (605) eine Vielzahl von Konfigurationsrezepten (613) umfasst, die mit jeweiligen Konfigurationen (611) der stapelbaren Zugangspunktvorrichtung verknüpft sind.

15. Basismodul (710) einer stapelbaren Zugangspunktvorrichtung (700), wobei das Basismodul (710) Folgendes umfasst:
eine Vielzahl von Schnittstellen (712a, 712b, 712c) und einen Prozessor (711), der dazu ausgelegt ist, Datenverkehr (713a, 713b, 713c) auf Basis einer Konfiguration (714) der stapelbaren Zugangspunktvorrichtung (700) über die stapelbare Zugangspunktvorrichtung (700) zu routen,
wobei das Basismodul (710) durch elektrisches Verbinden von mindestens einer Schnittstelle (712b) des Basismoduls (710) mit mindestens einer Schnittstelle (722a) des mindestens einen Erweiterungsmoduls (720) mit mindestens einem Erweiterungsmodul (720) der stapelbaren Zugangspunktvorrichtung (700) stapelbar ist,
wobei die Konfiguration (714) der stapelbaren Zugangspunktvorrichtung (700) auf einer Anzahl von Erweiterungsmodulen (720), die mit dem Basismodul (710) zusammengestapelt sind, und einer Reihenfolge, in der die mindestens ein Erweiterungsmodule (720) mit dem Basismodul (710) zusammengestapelt sind, basiert,
**dadurch gekennzeichnet, dass**
der Prozessor (711) des Basismoduls (710) dazu ausgelegt ist, auf Basis eines spezifischen Konfigurationsrezepts (613), das von einer Konfigurationsdatenbank (605) empfangen wird, einen spezifischen Routingpfad zum Routen des Datenverkehrs (713a, 713b, 713c) über die stapelbare Zugangspunktvorrichtung (700) zu bestimmen,
wobei die Konfigurationsdatenbank (605) eine Vielzahl von Konfigurationsrezepten (613) umfasst, die mit jeweiligen Konfigurationen (611) der stapelbaren Zugangspunktvorrichtung (700) verknüpft sind.

16. Basismodul (710) nach Anspruch 15,
wobei das Basismodul (710) in einer Basiskonfiguration der stapelbaren Zugangspunktvorrichtung (700) dazu ausgelegt ist, in einem eigenständigen Modus ohne Erweiterungsmodule (720) betrieben zu werden, und dazu ausgelegt ist, einen Basisdienst für den Datenverkehr (713a, 713b, 713c) bereitzustellen.

## Revendications

1. Dispositif de point d'accès empilable (700), comprenant :
un module de base (710), comprenant une pluralité d'interfaces (712a, 712b, 712c) et un processeur (711), le processeur (711) étant configuré pour acheminer un trafic de données (713a, 713b, 713c) à travers le dispositif de point d'accès empilable (700) selon une configuration (714) du dispositif de point d'accès empilable (700) ; et
au moins un module d'extension (720) spécifique à une technologie d'accès comprenant une pluralité d'interfaces (722a, 722b, 722c) et un processeur (721), le processeur (721) étant configuré pour traiter le trafic de données (723a, 723b, 723c) selon une technologie d'accès respective (724),
dans lequel ledit au moins un module d'extension (720) peut être empilé sur le module de base (710) par le branchement électrique d'au moins une interface (712b) du module de base (710) avec au moins une interface (722a) dudit au moins un module d'extension (720),
dans lequel la configuration (714) du dispositif de point d'accès empilable (700) dépend d'un nombre de modules d'extension (720) empilés sur le module de base (710) et d'un ordre dans lequel lesdits au moins un module d'extension (720) sont empilés sur le module de base (710),
**caractérisé en ce que**
le processeur (711) du module de base (710) est configuré pour déterminer un trajet d'acheminement spécifique pour l'acheminement du trafic de données (713a, 713b, 713c) à travers le dispositif de point d'accès empilable (700) selon une formule de configuration spécifique (613) reçue d'une base de données de configurations (605),
la base de données de configurations (605) comprenant une pluralité de formules de configuration (613) associées aux configurations respectives (611) du dispositif de point d'accès empilable (700).

2. Dispositif de point d'accès empilable (700, 100), selon la revendication 1,
dans lequel un premier module d'extension (102) desdits au moins un module d'extension (720) peut être empilé sur un deuxième module d'extension (103) desdits au moins un module d'extension (720) par un branchement électrique d'au moins une interface (112) du premier module d'extension (102) avec au moins une interface (122) du deuxième module d'extension (103).

3. Dispositif de point d'accès empilable (700, 100), selon la revendication 1 ou 2,
dans lequel ledit au moins un module d'extension (720, 102) peut être empilé sur le module de base (710, 101) par le placement dudit au moins un module d'extension (720, 102) et du module de base (710, 101) sur le dessus l'un de l'autre ou par le placement du module de base (710, 101) et dudit au moins un module d'extension (720, 102) sur le dessus l'un de l'autre.

4. Dispositif de point d'accès empilable (700, 100), selon l'une quelconque des revendications précédentes,
dans lequel au moins une partie des interfaces (712a, 712b, 712c) du module de base (710) et au moins une partie des interfaces (722a, 722b, 722c) dudit au moins un module d'extension (720) forment un bus (200) configuré pour relier électriquement le module de base (710) audit au moins un module d'extension (720).

5. Dispositif de point d'accès empilable (700, 300), selon l'une quelconque des revendications précédentes,
dans lequel le processeur (711) du module de base (710, 301) est configuré pour connecter un trafic de données (310) reçu par l'intermédiaire d'un premier module d'extension (302) desdits au moins un module d'extension (720) à un réseau de communication.

6. Dispositif de point d'accès empilable (700, 300), selon la revendication 5,
dans lequel le processeur (711) du premier module d'extension (302) est configuré pour traiter le trafic de données (310) selon une technologie d'accès Wifi.

7. Dispositif de point d'accès empilable (700, 400), selon l'une quelconque des revendications précédentes,
dans lequel le processeur (711) du module de base (710, 301) est configurée pour acheminer un trafic de données (310) reçu par l'intermédiaire d'un premier module d'extension (302) desdits au moins un module d'extension (720) vers un deuxième module d'extension (403) desdits au moins un module d'extension (720) pour la connexion à un réseau de communication.

8. Dispositif de point d'accès empilable (700, 400), selon la revendication 7,
dans lequel le processeur (721) du deuxième module d'extension (403) est configuré pour traiter le trafic de données (310) selon une technologie d'accès de ligne d'abonné numérique (DSL).

9. Dispositif de point d'accès empilable (700, 500) selon l'une quelconque des revendications précédentes,
dans lequel le processeur (721) d'un troisième module d'extension (504) desdits au moins un module d'extension (720) est configuré pour empaqueter (505) le trafic de données (510) reçu par l'intermédiaire d'au moins une interface du troisième module d'extension (504).

10. Dispositif de point d'accès empilable (700, 500), selon la revendication 9,
dans lequel le processeur (721) du troisième module d'extension (504) est configuré pour acheminer le trafic de données empaqueté à travers le troisième module d'extension (504) vers un réseau de communication par l'intermédiaire d'au moins une des interfaces suivantes : une interface de communication radio (512), une interface DSL (411), une interface Wifi.

11. Dispositif de point d'accès empilable (700) selon l'une quelconque des revendications précédentes,
dans lequel le processeur (711) du module de base (710) est configuré pour identifier (601) la configuration (714, 611) du dispositif de point d'accès empilable (700) en détectant, parmi les modules d'extension (720), ceux qui sont branchés sur le module de base (710) et dans quel ordre les modules d'extension (720) sont branchés sur le module de base (710) .

12. Dispositif de point d'accès empilable (700) selon l'une quelconque des revendications précédentes,
dans lequel le module de base (710) comprend un gestionnaire de réseau (603) configuré pour commuter les trajets de données du module de base (710) et desdits au moins un module d'extension (720) pour former le trajet d'acheminement spécifique servant à acheminer le trafic de données (713a, 713b, 713c, 723a, 723b, 723c) à travers le dispositif de point d'accès empilable (700).

13. Dispositif de point d'accès empilable (700), selon la revendication 12,
dans lequel le gestionnaire de réseau (603) comprend au moins une des entités suivantes :
un contrôleur de mise en réseau définie par logiciel (SDN), configuré pour commuter les trajets de données selon les règles SDN,
un serveur de protocoles de configuration d'hôte dynamique (DHCP) configuré pour commuter les trajets de données selon l'acheminement du protocole Internet (IP),
un contrôleur de LAN virtuel (VLAN) configuré pour commuter les trajets de données selon les étiquettes VLAN.

14. Procédé (800) d'acheminement de trafic de données à travers un dispositif de point d'accès empilable comprenant un module de base empilé sur au moins un module d'extension spécifique à une technologie d'accès, le procédé comprenant les étapes consistant à :
identifier (801) une configuration du dispositif de point d'accès empilable en détectant, parmi les modules d'extension, ceux qui sont branchés sur le module de base et dans quel ordre les modules d'extension sont branchés sur le module de base ;
déterminer (802) un trajet d'acheminement spécifique pour l'acheminement du trafic de données à travers le dispositif de point d'accès empilable d'après la configuration identifiée ; et
commuter (803) les trajets de données du module de base et desdits au moins un module d'extension pour former le trajet d'acheminement spécifique servant à acheminer le trafic de données à travers le dispositif de point d'accès empilable,
**caractérisé en ce que**
l'étape consistant à déterminer (802) le trajet d'acheminement spécifique consiste à déterminer le trajet d'acheminement spécifique selon une formule de configuration (613) reçue d'une base de données de configurations (605),
la base de données de configurations (605) comprenant une pluralité de formules de configuration (613) associées aux configurations respectives (611) du dispositif de point d'accès empilable.

15. Module de base (710) d'un dispositif de point d'accès empilable (700), le module de base (710) comprenant :
une pluralité d'interfaces (712a, 712b, 712c) ; et
un processeur (711) configuré pour acheminer un trafic de données (713a, 713b, 713c) à travers le dispositif de point d'accès empilable (700) selon une configuration (714) du dispositif de point d'accès empilable (700),
le module de base (710) pouvant être empilé sur au moins un module d'extension (720) du dispositif de point d'accès empilable (700) par le branchement électrique d'au moins une interface (712b) du module de base (710) avec au moins une interface (722a) dudit au moins un module d'extension (720),
dans lequel la configuration (714) du dispositif de point d'accès empilable (700) dépend d'un nombre de modules d'extension (720) empilés sur le module de base (710) et d'un ordre dans lequel lesdits au moins un module d'extension (720) sont empilés sur le module de base (710),
**caractérisé en ce que**
le processeur (711) du module de base (710) est configuré pour déterminer un trajet d'acheminement spécifique pour l'acheminement du trafic de données (713a, 713b, 713c) à travers le dispositif de point d'accès empilable (700) selon une formule de configuration spécifique (613) reçue d'une base de données de configurations (605),
la base de données de configurations (605) comprenant une pluralité de formules de configuration (613) associées aux configurations respectives (611) du dispositif de point d'accès empilable (700).

16. Module de base (710) selon la revendication 15,
le module de base (710), dans une configuration de base du dispositif de point d'accès empilable (700), étant configuré pour fonctionner dans un mode autonome sans module d'extension (720) et étant configuré pour fournir un service de base pour le trafic de données (713a, 713b, 713c).
